(19) Europäisches Patentamt

European Patent Office

Office européen des brevets

(11) **EP 1 376 852 B1**

(12) **EUROPEAN PATENT SPECIFICATION**

(45) Date of publication and mention
of the grant of the patent:
**08.11.2006 Bulletin 2006/45**

(51) Int Cl.:
***H03D 3/00*** *(2006.01)*

(21) Application number: **02013741.0**

(22) Date of filing: **20.06.2002**

(54) **I/Q Demodulator based on six-port circuit topologies for mobile receivers**

I/Q Demodulator unter Verwendung eines Sechs-Tor-Schaltung

I/Q Démodulateur utilisant un circuit à six ports

(84) Designated Contracting States:
**DE FR GB**

(43) Date of publication of application:
**02.01.2004 Bulletin 2004/01**

(73) Proprietor: **Sony Deutschland GmbH**
**10785 Berlin (DE)**

(72) Inventors:
• **Krupezevic, Dragan,**
**Sony International (Europe)**
**70327 Stuttgart (DE)**
• **Brankovic, Veselin,**
**Sony International (Europe)**
**70327 Stuttgart (DE)**

• **Ratni, Mohamed,**
**Sony International (Europe) GmbH**
**70327 Stuttgart (DE)**

(74) Representative: **Rupp, Christian et al**
**Mitscherlich & Partner**
**Patent- und Rechtsanwälte**
**Sonnenstrasse 33**
**80331 München (DE)**

(56) References cited:
| | |
|---|---|
| **EP-A- 0 805 561** | **EP-A- 0 896 455** |
| **EP-A- 0 957 573** | **EP-A- 1 067 675** |
| **EP-A- 1 172 927** | **WO-A- 02/05444** |
| **US-B1- 6 337 888** | |

**Description**

FIELD AND BACKGROUND OF THE INVENTION

The underlying invention generally relates to the field of mobile receivers with *N*-port circuit topologies, especially to a six-port junction device that can advantageously be used e.g. for the processing and direct down-conversion of broadband (modulated) RF band-pass signals within an operation bandwidth between 1 and 7 GHz, a mobile receiver comprising such a six-port junction device, and to a method for calibrating said mobile receiver.

Six-port technology is known to accurately measure both amplitude and phase of the scattering parameters in a microwave network. In contrast to heterodyne receivers, a six-port receiver accomplishes direct measurements at millimeter and microwave frequencies to perform a direct demodulation of received RF signals by extracting power levels at four of the six ports. The imperfections of the hardware such as phase errors of the bridges, imbalance of the power detectors, etc. can readily be eliminated by means of an appropriate calibration procedure. This significantly reduces the requirements of an hardware implementation and enables the six-port receiver to be operated within a wide band up to millimeter wave frequencies. Thereby, very accurate measurements can be made over a large dynamic range and a wide frequency range.

By employing adequate calibration procedures, the influences of the non-ideal passive RF components - including manufacturing tolerances - can be minimized. For example, a six-port receiver detects the relative phase and relative magnitude of two incoming RF signals. Its circuitry can be realized by passive components in combination with diodes for the detection of the relative phase and the relative amplitude of the RF signals. In this context, an important feature of six-port receivers consists in the possibility of calibrating fabrication tolerances, which inherently allows low-cost production.

BRIEF DESCRIPTION OF THE PRESENT STATE OF THE ART

According to the state of the art, there are different approaches and methods which are specially designed to cope with the problem of RF down-conversion using *N*-port technology. In order understand the basic idea of the underlying invention, it is necessary to briefly describe some of their characterizing features.

*N*-port technology (with $N \geq 2$ ports) can successfully be used for the processing of RF signals, thereby allowing a direct down-conversion from millimeter-wave range and microwave range to the baseband without needing any I/Q demodulation microchip (digital or analog). An *N*-port junction device in a conventional mobile receiver according to the state of the art that can be employed for the processing and direct down-conversion of modulated RF signals can ideally be considered

- as a structure with a perfect matching,

- as a structure that contains different sub-parts with a resistive or reactive power splitting functionality, and

- as a structure that may comprise at least one resistive power divider with an isolation function.

For all of these cases, it shall be assumed that the power detector structures are ideally matched. Their number may vary from one to (*N*-2). In reality however, due to the manufacturing process, the passive and active parts react in such a way that the ideal functionality of the sub-parts is not fulfilled, which means that a calibration procedure is necessary to cope with this problem.

PCT/EP98/08329 refers to an *N*-port junction device (with $N \geq 4$ ports) which is used in the receiver of a mobile telecommunications device for processing modulated RF signals. It comprises two RF input ports, two passive signal combining units connected to each other by means of a phase shifting element, wherein the first one of said passive signal combining units is fed with a first RF input signal and the second one of said passive signal combining units is fed with a second RF input signal. Additionally, said *N*-port junction device comprises at least two power sensors, each connected to one of the output ports of said passive signal combining units.

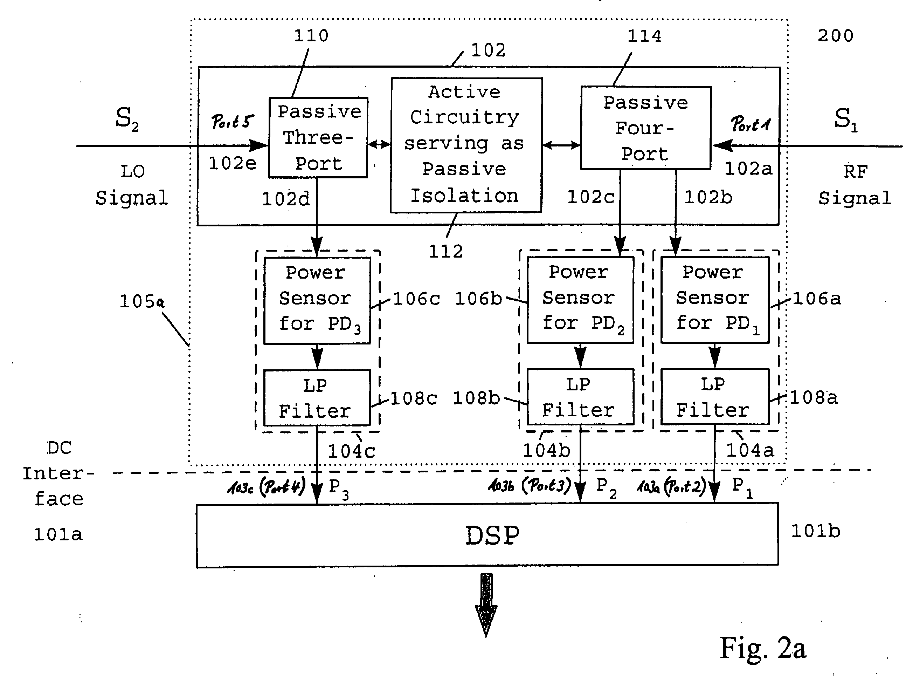

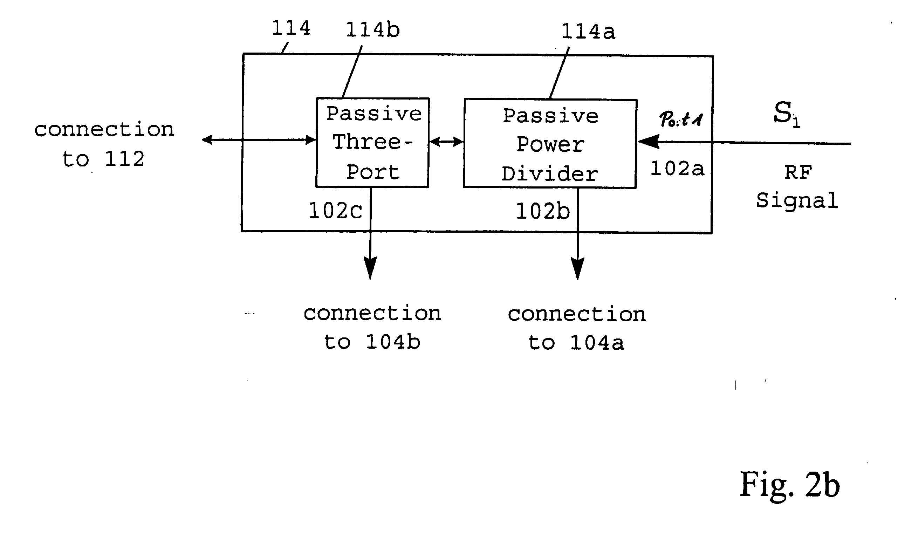

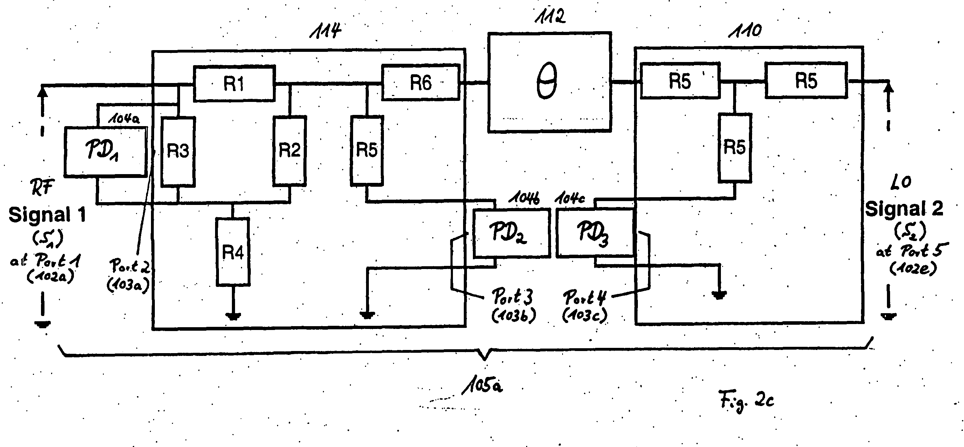

From EP 0 957 573 A1, a five-port junction device is known which can be used for processing received RF signals in order to perform a direct down-conversion of said RF signals. The device comprises a passive four-port network being connected with a passive three-port network by means of a phase shifter. Thereby, one port of said passive four-port network acts as an input port used for the input of a first RF signal, and two ports of said passive four-port network act as output ports. The passive three-port comprises one port used for the input of a second RF signal and one output port. In the disclosed topology, a passive isolation is provided as depicted in Figs. 2a+b.

One of the important issues in the five-port network design is the isolation between the local oscillator (LO) and radio frequency (RF) input signals. The corresponding solution according to the state of the art is in EP 1 061 660 A1, wherein the isolation is provided by an active device.

Therein, an *N*-port RF receiver (with $N \geq 3$ ports) for modulated RF signals is proposed, which is based on a *N*-port junction device providing an isolation between the RF signal and the LO signal. In the preferred embodiment of said invention, the disclosed *N*-port junction is supplied with a first RF signal at a first input port (RF port) and with a second RF signal originating from a local oscillator (LO) at a second input port (LO port). Furthermore, the *N*-port junction contains an RF/LO isolation block comprising a non-reciprocal active circuitry for isolating the LO signal from the RF signal. Thereby, it can be ensured that the LO signal is significantly attenuated at the RF input port.

An alternative way to provide an effective isolation by passive means is the usage of hybrid printed microwave circuits. However, this approach requires a specific implementation topology and a four-port approach, wherein usually one port is out of use and has to be terminated by an impedance of 50 Ω. In the cited approach according to the state of the art several of those hybrid printed microwave circuits are combined in order to provide the required phase shifts.

Six-port receivers as disclosed in EP-A-0 896 455 are known for enabling a direct down-conversion of received modulated RF signals from millimeter wave and microwave range to the baseband. Thereby, the six-port receiver detects the phase difference and the amplitude ratio of two incoming RF signals by using the information of superimposed, mutually interfering RF signals. To perform the down-conversion of the modulated RF signals, a classical I/Q demodulator is not needed. With the aid of suitable calibration procedures, the influence of non-ideal linear RF components (including manufacturing tolerances of these components) can be minimized. The circuitry of six-port receivers can be realized by only employing passive components in combination with power sensors for the detection of the phase difference and the amplitude ratio of said RF signals. An important feature of six-port receivers is that fabrication tolerances of the employed RF components can be calibrated, which inherently allows the usage of low-cost RF components.

US 5,498,969 discloses a six-port junction device of a mobile receiver that can advantageously be applied to vector measurement of ultra-high frequency signals of the same angular frequency. It comprises one power divider and one phase shifting circuit. Two of the six ports of said six-port junction device are measuring ports that can be connected with two RF sources; the four other ports are connected with four power detectors. Thereby, one of them is a matched power detector, and the other three power detectors are unmatched.

A structure for a six-port receiver is proposed in the IEEE MTT Symposium report "A Six-Port Direct Digital Millimeter Wave Receiver" (Digest of the IEEE MTT Symposium, vol. 3, pp. 1659 to 1662, San Diego, May 1994) by J. Li, R. G. Bossisio and K. Wu. Therein, a novel scheme for a digital phase demodulation of modulated millimeter waves and microwaves by means of a six-port receiver is presented. By virtue of said scheme, some disadvantages of conventional receivers, wherein I/Q demodulators are used for a direct down-conversion of the received RF signals, are overcome.

In the article "A Six-Port Direct Digital Millimeter Wave Receiver" (Digest of the IEEE MTT Symposium, vol. 3, pp. 1659-1662, San Diego, May 1994) by J. Li, R. G. Bossisio and K. Wu, EP 0 957 573 A1 and the US patent 5,498,969, a calibration procedure for a reduction or compensation of non-linear effects caused by imperfections of the herein employed circuit elements is proposed. Due to the manufacturing process, the passive and active parts react in such a way that ideal functionality of the sub-parts is not fulfilled. Therefore, a calibration procedure is recommended to solve this problem.

Among a plurality of algorithms which have been proposed for the calibration of six-port reflectometers (SPRs), Engen's six-port-to-four-port reduction, as described in the two articles "Calibrating the Six-Port Reflectometer by Means of Sliding Terminations" (IEEE Trans. Microwave Theory Tech., vol. MTT-26, pp. 951-957, Dec. 1978) by G. F. Engen, and "'Thru-Reflect-Line': An Improved Technique for Calibrating the Dual Six-Port Automatic Network Analyzer" (IEEE Trans. Microwave Theory Tech., vol. MTT-27, pp. 987-993, Dec. 1979) by G. F. Engen and C. A. Hoer, seems to be one of the more attractive choices. This procedure determines the dependencies between the different power meter readings, yielding five real-valued reduction parameters which permit to transform the SPR into a virtual four-port. No known standards are required for this reduction. The value measured by the virtual four-port is related to the reflection coefficient of the device under test by a so-called "error box" transformation. The three complex parameters of this transformation may be found by using one of the many existing methods for the calibration of traditional network analyzers.

One of the great advantages of Engen's method is that it makes an efficient use of the redundancy contained in the power meter readings. In fact, the values of the five real parameters of the six-port-to-four-port reduction may be optimized with respect to a non-linear constraint equation containing the parameter values and the power meter readings. This optimization often permits to significantly improve the accuracy of measurements made with the SPR. However, good initial estimates of the five parameters are needed for the optimization to converge.

A further popular algorithm for finding the initial estimates, which has also been described in the article "'Thru-Reflect-Line': An Improved Technique for Calibrating the Dual Six-Port Automatic Network Analyzer" (IEEE Trans. Microwave Theory Tech., vol. MTT-27, pp. 987-993, Dec. 1979) by G. F. Engen and C. A. Hoer, uses nine or more completely unknown but well-distributed loads. However, this method generally requires a large number of measurements during calibration. It also seems to have some problems in cases where all the reflection coefficients of the unknown loads used for the calibration have approximately the same absolute value.

Another approach for a linear calibration of an *N*-port receiver (with $N = 5$ or $N = 6$ ports) is disclosed in EP 1 067 675 A1. Said *N*-port receiver comprises a first input port for an RF signal $S_1$ to be detected, a second input port for an RF signal $S_2$ originating from a local oscillator (LO) and (*N*-2) output terminals. Thereby, calibrating signals are generated on the basis of the RF signal $S_2$ supplied by the local oscillator and fed to the first input port and/or the second input port of said *N*-port receiver. The calibration coefficients are calculated on the basis of the output signals generated by the *N*-port receiver in response to the feeding of the calibration signals. In this connection, the calibration signals are unmodulated signals and are only processed by means of a passive RF circuitry in the calibration device. The proposed approach allows a simple calibration of *N*-port receivers, which can be used as I/Q demodulators or converters. Thereby, a local oscillator (LO) is used as an RF source for said calibration process. In contrast to Engen's calibration method mentioned above, the herein described calibration procedure uses an unchanged LO power level, which makes the computation effort less complicated.

DEFICIENCIES AND DISADVANTAGES OF THE KNOWN SOLUTIONS ACCORDING TO THE STATE OF THE ART

A problem that arises when conventional power detectors, which can simply be realized as commercially available detector diodes, are deployed as basic elements for the down-conversion of modulated RF band-pass signals in a mobile receiver is their non-linear behavior caused by imperfections of their analog electronic components. These imperfections determine the dynamic range, which is especially important in case of a direct down-conversion, since they limit the range wherein the behavior of said power detectors can be approximated as linear.

OBJECT OF THE UNDERLYING INVENTION

In view of the explanations mentioned above, it is therefore the object of the underlying invention to propose a calibration technique for power detectors in a mobile receiver topology which can be used for measuring, processing and direct down-converting modulated RF signals, thereby increasing its dynamic range and keeping the same linearity of said power detectors for the whole dynamic range.

This object is achieved by means of the features in the independent patent claims. Advantageous features are defined in the dependent patent claims.

SUMMARY OF THE INVENTION

The proposed approach according to the underlying invention is basically dedicated to a non-linear calibration procedure and its associated hardware, which allows a mobile receiver with a six-port-like circuit topology for the processing and direct down-conversion of modulated broadband RF band-pass signals to be operated with an increased dynamic range. This means to cope with operation mode when the signals at the output ports of the herein applied power detectors are in non-linear range. One of the consequences is that the vector signal error decreases by using demodulation in a non-linear manner compared to conventional solutions according to the state of the art. The main difference between the applied implementation according to the proposed solution and the state of the art is that seven complex calibration coefficients are needed, which leads to an increased deployment of the analog and/or digital processing hardware, instead of only four coefficients needed for conventional solutions. However, this effort pays off since a compensation of the non-linear power detector characteristics can be achieved for the whole dynamic range.

BRIEF DESCRIPTION OF THE CLAIMS

The independent claim 1 and the dependent claims 2 to 5 refer to a quadrature demodulator attached to a six-port junction device of a mobile receiver used for the processing and direct down-conversion of a modulated RF band-pass signal ($S_1$) to the baseband represented by the quadrature components (I and Q) of the equivalent low-pass signal forming the complex envelope of said RF band-pass signal. Thereby, said quadrature demodulator is capable of providing inphase (I) and quadrature (Q) signals serving as equivalent low-pass signals of said modulated RF band-pass signal by calculating a linear combination of the power detector readings ($P_1$, $P_2$, $P_3$, and $P_4$) measured by the power detectors and a linear combination of the squared power detector readings ($F_1$, $F_2$, $F_3$, and $F_4$) for a non-linear mismatch compensation of the inphase signal (I) and/or the quadrature signal (Q).

In addition, the independent claim 6 and the dependent claim 7 are directed to a non-linear calibration hardware for calibrating a mobile receiver.

The dependent claims 8 to 13 pertain to a calibration method for compensating mismatches of the inphase signal (I) and/or quadrature signal (Q) using a non-linear calibration hardware according to anyone of the claims 6 and 7.

Finally, the dependent patent claim 14 refers to a receiver of a mobile telecommunications device for the processing and direct down-conversion of a modulated RF band-pass signal ($S_1$) to the baseband. Therein, a quadrature demodulator according to anyone of the claims 1 to 5 and a non-linear calibration hardware according to anyone of the claims 6 and 7 attached to said six-port junction device are applied.

BRIEF DESCRIPTION OF THE DRAWINGS

Further advantages of the invention will now be explained by means of the following description of two preferred embodiments of the invention which are depicted in the following drawings. Herein,

Fig. 1        presents a block diagram showing a general overview of the circuit topology for a mobile receiver comprising a five-port junction device with three power detectors and a digital signal processor according to the state of the art,

Fig. 2a       shows a block diagram of a non-reciprocal active circuitry for a five-port junction device according to the state of the art providing a passive isolation between the RF signal $S_1$ and the LO signal $S_2$,

Fig. 2b       shows a detailed view of the components contained in the passive four-port network according to the state of the art,

Fig. 2c       shows a five-port circuit topology according to the state of the art using resistive elements, for which the proposed solution according to the underlying invention can be applied,

Fig. 2d       shows a five-port topology according to the state of the art using a very simple approach with three power detectors and one capacitor between the two upper nodes (A and B) of said five-port junction device, for which the proposed solution according to the underlying invention can be applied,

Fig. 3        exhibits the topology of a first analog circuitry (here: a DC amplifier network attached to the DC interface) according to one embodiment of the underlying invention that is employed to calculate the inphase (I) and quadrature (Q) signal according to three power detector readings ($P_1$, $P_2$, and $P_3$), thereby using analog means to execute the proposed non-linear calibration approach,

Fig. 4        exhibits the topology of a second analog circuitry (here: a DC amplifier network attached to the DC interface) according to one embodiment of the underlying invention that is employed to calculate the inphase (I) and quadrature (Q) signal according to three power detector readings ($P_1$, $P_2$, and $P_3$), wherein the proposed non-linear calibration approach is implemented within a digital processing block,

Fig. 5        shows the basic idea of eliminating the problems caused by the non-linear behavior of a mobile receiver with a six-port circuit topology according to the state of the art according to the underlying invention by comparing a linear and a non-linear model for the quadrature demodulator of a five-port receiver structure,

Fig. 6        outlines a block diagram showing a mobile receiver with a six-port circuit topology and its calibration hardware, which is capable of executing different calibration set-up options for the calibration procedure according to the underlying invention,

Fig. 7        exhibits one diagram showing the non-linear behavior of a commercially available power detector and two simulation circuitries serving as topologies for a single-ended and a differential power detector, respectively,

Fig. 8        presents two I/Q diagram showing the equivalent low-pass signal serving as a complex baseband signal of the down-converted RF signal $S_1$ after having applied a linear calibration procedure according to the state of the art for low and high RF power levels at the input port of a mobile receiver with a six-port circuit topology according to the state of the art when non-linear effects of said receiver become significant, and

Fig. 9        presents two I/Q diagram showing the equivalent low-pass signal serving as a complex baseband signal of the down-converted RF signal $S_1$ after having applied a non-linear calibration procedure according to the proposed approach of the underlying invention for low and high RF power levels at the input port of a mobile receiver with a six-port circuit topology according to the state of the art when non-linear effects of said receiver become significant.

DETAILED DESCRIPTION OF THE UNDERLYING INVENTION

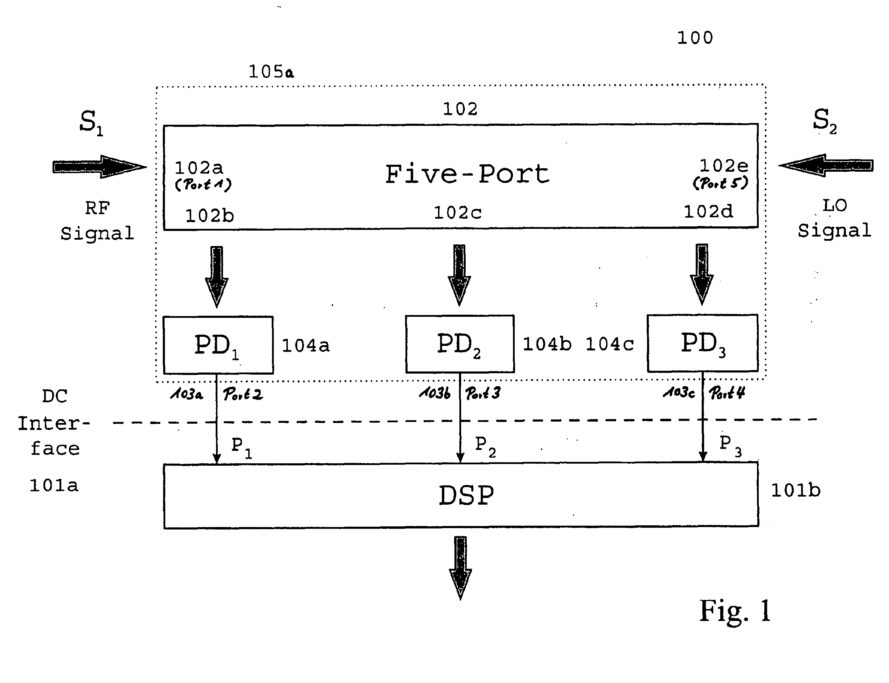

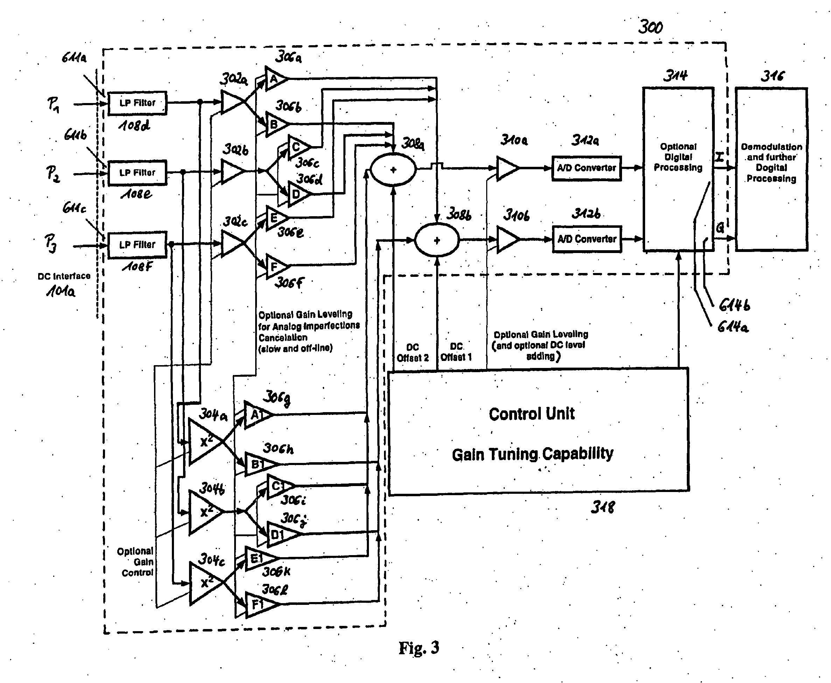

In the following sections, the functions of the components and signals in one embodiment of the underlying invention as depicted in Figs. 3 to 6 and 9 are explained in comparison with an already known solution according to the state of the art as depicted in Figs. 1, 2a-d, 7, and 8. The meaning of the symbols designated with reference signs in Figs. 1 to 9 can be taken from the appended table of reference signs.

In Fig. 1, a block diagram is depicted which gives a general overview of the circuit topology for a conventional mobile receiver according to the state of the art. The herein disclosed structure comprises a five-port junction device 102 connected with three power detectors 104a-c and a digital signal processor 101b (DSP). In this structure, the five-port junction device 102 acts as a passive isolation between a received first RF signal $(S_1)$ and a second RF signal $(S_2)$ that originates from a local oscillator 608a (LO). In the following, the input signal $S_1$ shall be called "RF signal", and the input signal $S_2$ shall be called "LO signal".

The basic concept of said five-port topology can be taken from Fig. 2a, which shows a block diagram of a non-reciprocal active circuitry 112 for a five-port junction device 102 according to the state of the art providing a passive isolation between the RF signal $(S_1)$ and the LO signal $(S_2)$. It comprises one passive four-port network 114 and one passive three-port network 110 connected with each other by a non-reciprocal active circuitry 112 which acts as a passive isolation between the RF signal $(S_1)$ and the LO signal $(S_2)$. Thereby, $S_1$ and $S_2$ are the input signals of the passive four-port network 114 and the passive three-port network 110, respectively.

The passive three-port network 110 comprises one port 102e for the input of the LO signal $(S_2)$, one port for the connection with the non-reciprocal active circuitry 112 and one port 102d for the output of a signal representing the power level $P_3$ measured by the power sensor 106a/b/c. By contrast, the passive four-port network 114 comprises one port 102a for the input of the RF signal $(S_1)$, one port for the connection with the non-reciprocal active circuitry 112 and two ports 102b+c for the output of two signals representing the power levels $P_1$ and $P_2$ measured by the power sensors 106a-c, respectively. When the disclosed topology is used as a receiver, the power sensors 106a-c are matched, for example on an impedance of 50 Ω.

The output signals of the passive four-port network 114 and the passive three-port network 110 represent linear combinations and eventually phase shifts of the input signals $(S_1$ and $S_2)$, as known from the technical field of six-port receivers 602. The power sensors 106a-c detect the power levels $(P_1, P_2$ and $P_3)$ of the output signals at the output ports 103a-c of the passive five-port network, which are then supplied to a digital signal processor 101b (DSP). Usually, a plurality of circuit elements, such as low-pass filters 108a-f, DC amplifiers and analog-to-digital converters 312a+b, are connected between each of said power sensors 106a-c and the digital signal processor 101b, which are not shown in this figure.

Fig. 2b presents a detailed view of the components contained in the passive four-port network 114 according to the state of the art. These components comprise a passive power divider 114a and a passive three-port network 114b connected to each other and with the output ports 102b+c of said passive four-port network 114.

In the scope of the proposed non-linear calibration procedure, which is used for a verification of the proposed solution with three power sensors 106a-c, a resistive five-port topology according to the state of the art is deployed as depicted in Fig. 2c.

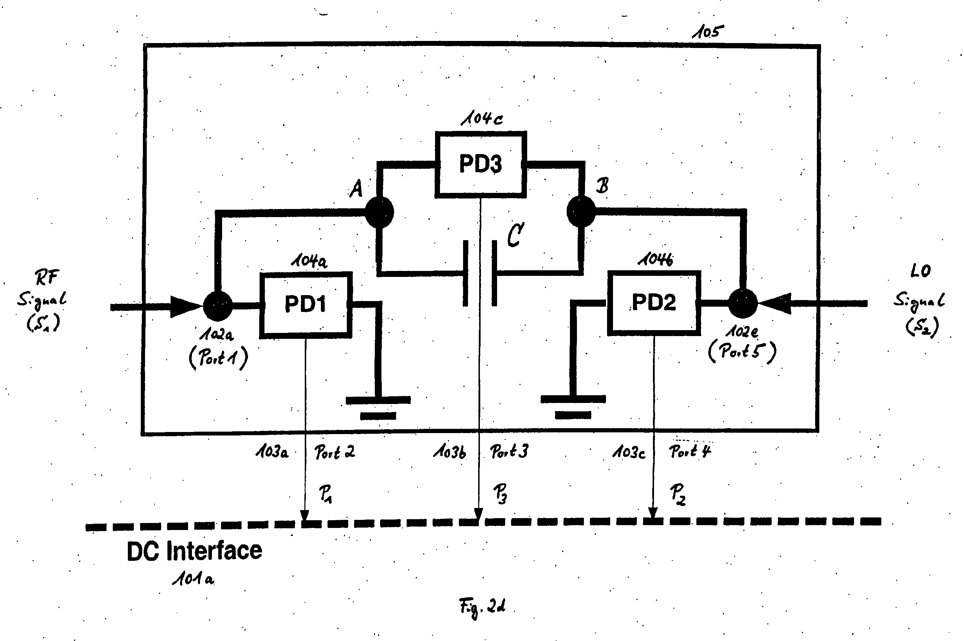

Moreover, Fig. 2d shows a five-port topology according to the state of the art using a very simple approach with three power detectors 104a-c and one capacitor between the two upper nodes (A and B) of said five-port junction device 102, for which the proposed solution according to the underlying invention can also be applied.

In this connection, it should be noted that the proposed non-linear calibration procedure may be applied for both five-port topologies and any mobile receivers 602 with six-port circuit topologies known from literature.

Fig. 3 exhibits the topology of a first analog circuitry 300/400 (here: a DC amplifier network attached to the DC interface 101a) according to one embodiment of the underlying invention that is employed to calculate the inphase (I) and quadrature (Q) signal according to the three power detector readings $(P_1, P_2,$ and $P_3)$ measured by the power detectors 104a-c, thereby using analog means to execute the proposed non-linear calibration approach. These analog circuitries are means of an implementation according to the proposed solution. The final output signals of the proposed circuitry, for which the non-linear calibration procedure is applied, are I/Q output signals without any digital processing. The DC operation amplifier network is connected to the output of the power detectors 104a-c (after filtering) at the output ports 103a-c of the power detectors 104a-c. These signals are then multiplied with prescribed constants (provided by the proposed calibration procedure) and added to calculate the I and Q signals, respectively. One portion of the input values $P_1, P_2$ and $P_3$ are then squared by analog means and multiplied by the rest of the DC constants before taking part in summation. Thereby, the proposed analog circuit topology is an implementation option of the proposed non-linear calibration method. Furthermore, it should be noted that the proposed non-linear calibration procedure is performed in baseband with the aid of a digital processing block 314.

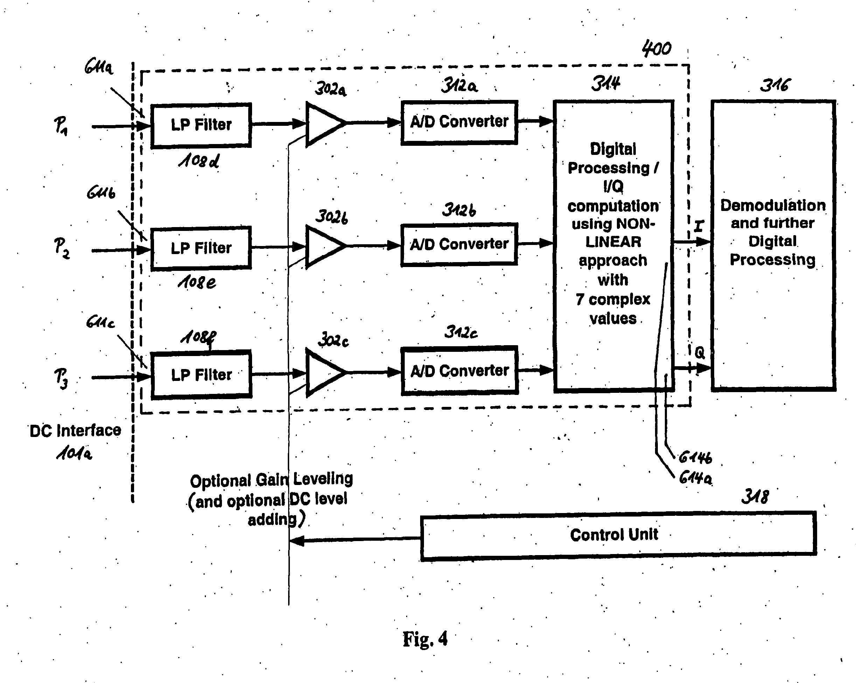

Fig. 4 exhibits the topology of a second analog circuitry 300/400 (here: a DC amplifier network attached to the DC interface 101a) according to one embodiment of the underlying invention that is employed to calculate the inphase (I) and quadrature (Q) signal according to three power detector readings ($P_1$, $P_2$, and $P_3$), wherein the proposed non-linear calibration approach is implemented within a digital processing block 314. Thereby, the proposed digital circuit topology is an implementation option of the proposed non-linear calibration method.

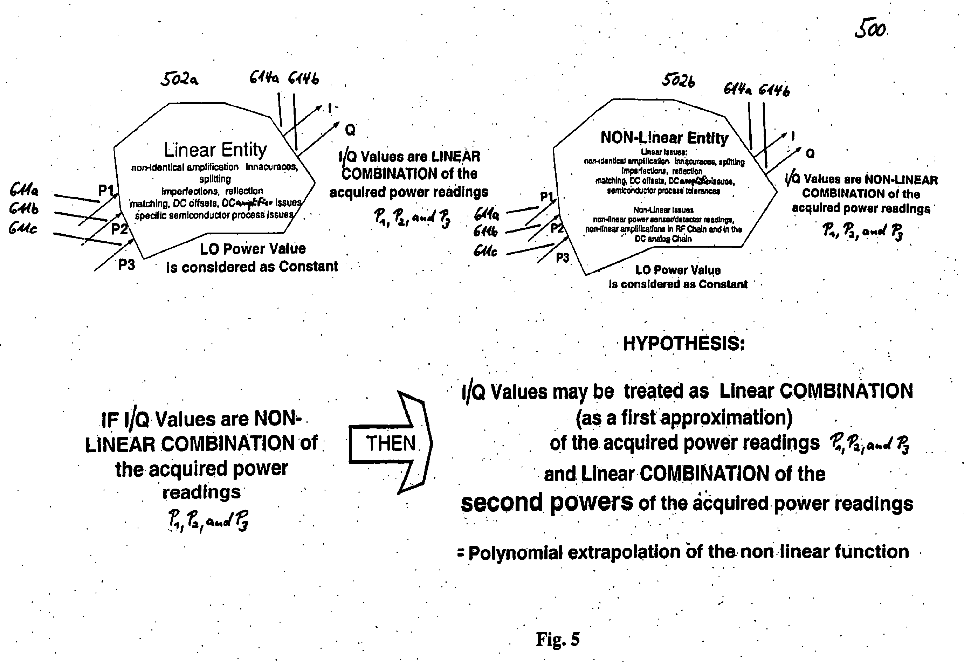

In Fig. 5, the basic idea 500 of eliminating the problems caused by the non-linear behavior of the six-port receiver 602 structure according to the underlying invention is shown with the aid of a linear model for the quadrature demodulator 502b of a five-port receiver structure implying impairments caused by non-identical amplification inaccuracies, splitting imperfections, reflection matching, DC offsets, DC amplifier issues, and specific semiconductor process issues, and a non-linear model for the quadrature demodulator 502b of a five-port receiver structure being additionally impaired by non-linear power detector readings, non-linear amplifications in the RF chain and in the analog DC chain, which serve as models for the quadrature demodulator 502b of a five-port receiver structure. In this connection, the I/Q values are approximated as a linear combination of the measured power detector readings $P_1$, $P_2$ and $P_3$, and a linear combination of their squared values, if said I/Q values are a non-linear function of said power detector readings $P_1$, $P_2$ and $P_3$, thereby yielding a polynomial extrapolation of said non-linear function.

In the following sections, the hardware realization for the analog I/Q demodulation part, the inventive method of operation and its implementation alternatives shall be presented. Moreover, the applied calibration procedure for the calculation of the required calibration coefficients shall be described in detail.

According to the underlying invention, a mobile receiver 602 with a six-port circuit topology using an extended analog and/or digital hardware is proposed which provides an increased dynamic range compared to conventional solutions according to the state of the art. Thereby, an additional analog hardware and/or digital processing functionality is disclosed, which is used for the squaring and further processing of the power detector readings which are needed for the approximation of the I/Q values according to the inventive calibration method.

Although the feasibility of the proposed calibration procedure does not depend on the available number of ports, the underlying invention is preferably designed for mobile receivers with five- or six-port circuit topologies with three or four power detectors 104a-c, respectively.

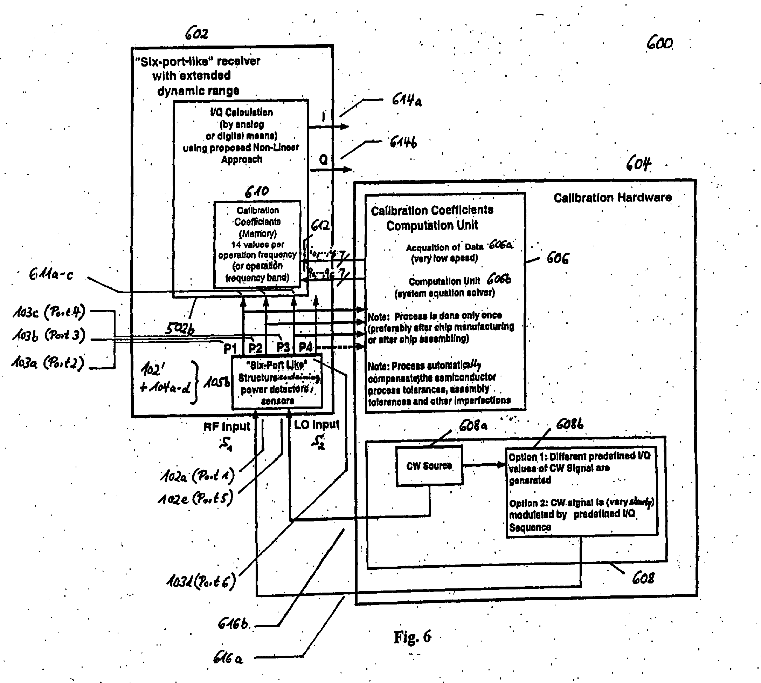

Fig. 6 outlines a block diagram showing a mobile receiver 602 with a six-port circuit topology and its calibration hardware 604, which is capable of executing different calibration set-up options 608b for the calibration procedure according to the underlying invention. It should be noted that for the proposed calibration procedure separate hardware devices are used.

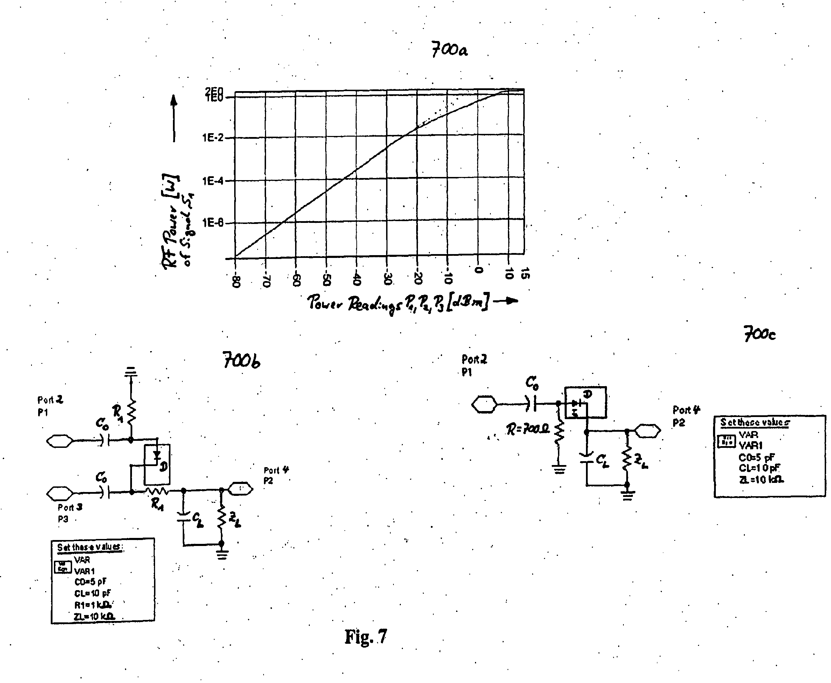

Fig. 7 outlines a diagram showing the non-linear behavior of a commercially available power detector 104a-c and two simulation circuitries 700b/c serving as topologies for a single-ended and a differential power detector 104a/b/c, respectively. Thereby, the applied power detector 104a/b/c is a commercially available detector diode. It can be seen that the behavior of said power detector 104a/b/c is non-linear over -20 dBm. In the left and right corner of Fig. 7, simulation topologies for single-ended and differential power detectors 104a-c are shown.

The proposed approach can easily be verified with the aid of a classical six-port structure 105b according to the state of the art, in which the chosen power detectors 104a-c are commercial detector diode models.

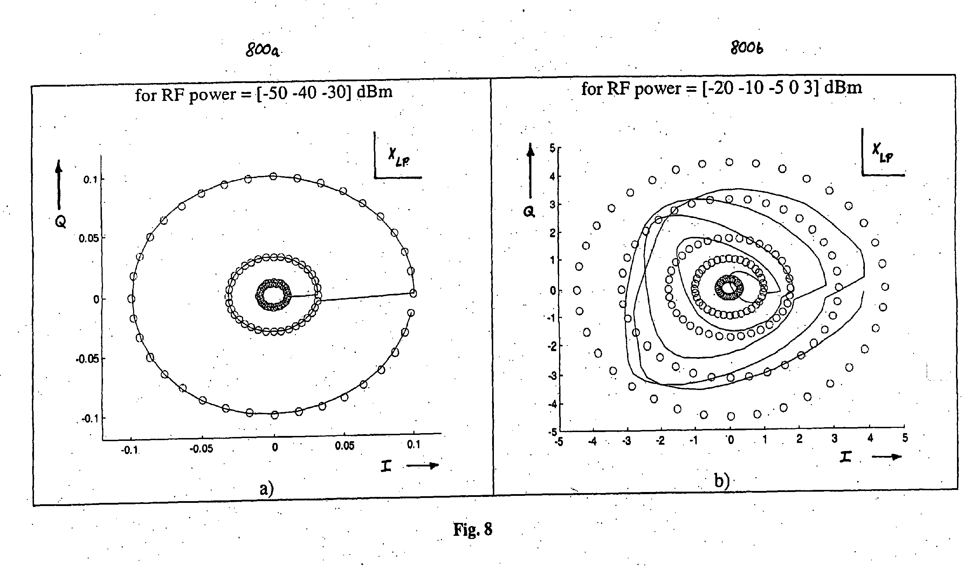

Fig. 8 presents two I/Q diagram showing the equivalent low-pass signal serving as a complex baseband signal of the down-converted RF signal $S_1$ after having applied a linear calibration procedure according to the state of the art for low RF power values (-50, -40, and -30 dBm) and high RF power levels (-20, -10, -5, 0, and +3 dBm) at the input port 102a of a mobile receiver 602 with a six-port circuit topology according to the state of the art when non-linear effects of said receiver become significant. On the left, it is shown that linear calibration performs well for lower RF levels at the input port 102a of the mobile receiver 602 with a six-port circuit topology. On the right, it is shown that linear calibration procedure is not able to perform when non-linear effects of the mobile receiver become significant. (In a simulation, this is the case for RF input levels over -15 dBm due to the non-linear behavior of the applied power detector 104a-c structures.) Furthermore, it should be noted that the circles refer to the positions of the RF signal to be detected in a complex plane, and the continuous lines refer to the detected I/Q values. Thereby, said simulations are performed if the input RF level is constant and the phase of the RF signal varies from 0° to 360°.

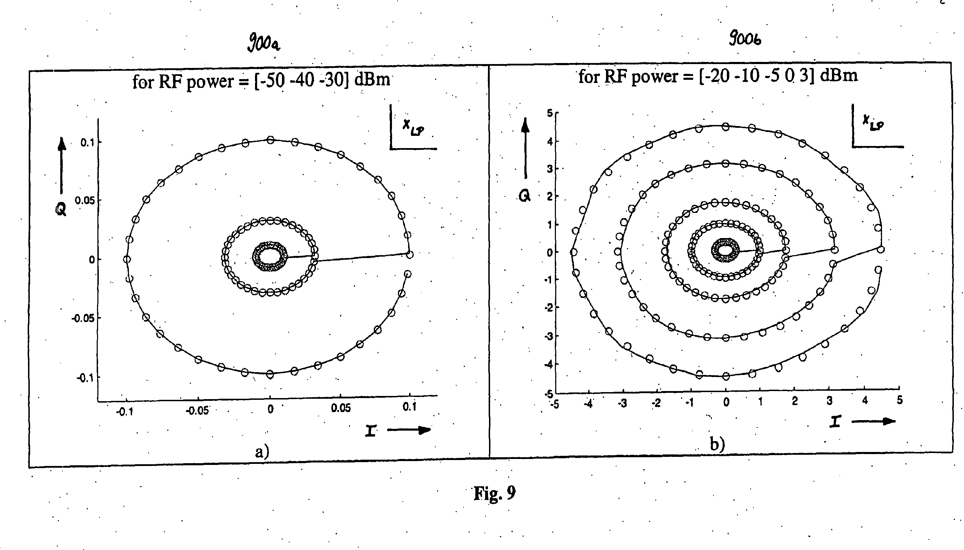

Fig. 9 presents two I/Q diagram showing the equivalent low-pass signal serving as a complex baseband signal of the down-converted RF signal $S_1$ after having applied a non-linear calibration procedure according to the proposed approach of the underlying invention for low RF power values (-50, -40, and -30 dBm) and high RF power levels (-20, -10, -5, 0, and +3 dBm) at the input port 102a of a mobile receiver 602 with a six-port circuit topology according to the state of the art when non-linear effects of said receiver become significant. On the left, it is shown that non-linear calibration performs well for lower RF levels at the input port 102a of the mobile receiver, which does not imply any advantages compared with a linear (more simple) calibration approach. On the right, it is shown that the non-linear calibration procedure is able to perform well, even in case severe non-linear effects of the mobile receiver become significant. (In a simulation, this is the case for RF input levels over -15 dBm due to the non-linear behavior of the applied power detector 104a-c structures.) Again, it should be noted that the circles refer to the positions of the RF signal to be detected in a complex plane, and the continuous lines refer to the detected I/Q values. Said simulations are performed if the input RF level is constant and the phase of the RF signal varies from 0° to 360°.

For the simulations depicted in Fig. 8 and Fig. 9, the same receiver was applied. In case the calibration method according to the inventive approach is used, approximately 20 dB extension of the dynamic range may be achieved.

In the following sections, the applied calibration method according to the proposed approach of the underlying invention shall be described in detail. In this connection, a simplified example with three output ports 103a-c shall be considered, which refers to a five-port structure 105a. Thereby, it should be noted that the employed structure is generally an I/Q demodulator 502b structure, wherein the LO power level is constant.

Before the calibration can start, an RF signal is fed to the input port 102a of a "six-port-like" structure 105b which is integrated in the mobile receiver 602. Its output ports are usually the output ports 103a-c of the power detectors 104a-c. Then, the power levels are treated in such a way that the inphase (I) and quadrature (Q) values can be calculated by means of the following equations:

$$I = h \cdot \left( i_0 + \sum_{k=1}^{3} i_k \cdot P_k + \sum_{k=1}^{3} i_{k+3} \cdot F_k \right) \text{ and} \qquad (1)$$

$$Q = h \cdot \left( q_0 + \sum_{k=1}^{3} q_k \cdot P_k + \sum_{k=1}^{3} q_{k+3} \cdot F_k \right), \qquad (2)$$

with

$$F_k := P_k^2 \text{ for } k \in \{1, 2, 3\}.$$

If the power detectors 104a-c of the mobile receiver work in linear range, the inphase (I) and quadrature (Q) values may be calculated as given by equations (1) and (2). The $h$-coefficients are related to the calibration coefficients. It can be observed that in case larger signals (that are closer to the compression point) are fed to the power detector 104a-c, input I/Q values which have been calculated with the aid of equations (1) and (2) do not yield the right results.

This means that for an approximation of the I/Q values a linear combination of the power detector readings as well as a linear combination of their squares is needed, which are calculated with the aid of an analog and/or digital hardware realization.

Comparing equations (1) and (2) with conventional solutions according to the state of the art, e.g. as given by the following equations

$$I = h \cdot \left( i_0 + \sum_{k=1}^{3} i_k \cdot P_k \right) \text{ and} \qquad (3)$$

$$Q = h \cdot \left( q_0 + \sum_{k=1}^{3} q_k \cdot P_k \right), \qquad (4)$$

it can be seen that the new set of equations is more complex since it needs six more coefficients. These coefficients are obtained by an execution of the calibration procedure.

The I/Q calculation is performed by analog means as depicted in Fig. 3, or by means of a digital DC processing block as depicted in Fig. 4. It should be noted that analog processing may lead to a reduced power consumption and digital complexity, especially if applications using higher data rates are required. An analog realization, preferably in CMOS technology, may lead to an integration of a six-port receiver 602 with the proposed analog circuitry 300/400 on the same chip.

The basic motivation for applying the calibration idea mathematically as described in equations (1) and (2) can be taken from Fig. 5. For example, if a linear calibration procedure offers the possibility to calculate the inphase (I) and quadrature (Q) values as a linear combination of the power detector readings, a similar approach can advantageously be extended to the non-linear behavior of the applied power detectors 104a-c. In the following, it shall be assumed that non-linear dependencies of the input values may be approximated by a polynomial extrapolation. It shall further be considered by approximation, that the I/Q values may be described by a second-order polynomial. Hence, equations (1) and (2) are only valid if the polynomial expansion of the non-linear behavior is allowed.

However, it is important to state that the non-linear calibration proposed in equation (1) and (2) may be extended in such a way that higher-order polynomials can be applied. This may increase the accuracy of the modeling and the finally obtained quadrature components (I and Q), but, at the same time, its practical realization as shown in Fig. 3 and Fig. 4 is much more complicated and would require even more power consumption. Therefore, the proposed idea according to the underlying invention, wherein second-order polynomials utilizing squared power levels as additional calibration coefficients are employed, presents a trade-off for which an extension of the dynamic range about 20 dB may be accomplished. This extension is achieved by means of a reasonable extension of the required hardware complexity and power consumption.

In general, power detectors 104a-c which are realized by active devices or commercial detector diodes show non-linear characteristics. These power detectors 104a-c may efficiently be used for small signals in linear range, but for larger signals the dynamic range of said devices is limited due to the non-linear behavior of conventional power detectors 104a-c.

By using the proposed approach according to the underlying invention as given by equations (1) and (2), the dynamic range of operation can significantly be increased. Thereby, the following points should be taken into account:

1. It should be noted that the procedure targeting to obtain the coefficients $h_{I0},...., h_{I6}$ and $h_{Q0}, ... ,h_{Q6}$ is performed off-line during the process of chip manufacturing or after its assembly, and that these values are stored on the chip before said chip is used. Said coefficients are used for setting the analog gains of the applied variable gain amplifiers 302a-c, 304a-c, 306a-1, and 310a+b serving as analog weight factors or the amplification coefficients in a digital processing hardware.

2. In case of an analog processing and I/Q calculation, the measured power levels $P_1$, $P_2$, and $P_3$ at the output ports 103a-c of said power detectors 104a-c are multiplied with the derived coefficients, and the signals are then squared and multiplied by the rest of the coefficients and added, thereby yielding the desired quadrature components (I and Q) as depicted in Fig. 3. This is done with the aid of variable gain amplifiers 302a-c, 304a-c, 306a-1, and 310a+b with known gains, for each of the branches referring to a non-linear calibration coefficient. In case of digital processing and I/Q calculation, equations (1) and (2) may be realized in the digital DC processing block by using the calibration coefficients which are stored there.

The calibration procedure is preferably done off-line after chip manufacture or chip assembly. It should be noted that said chip is attached to a six-port receiver 602 with maximal four power detectors 104a-c. Furthermore, it should be noted that a plurality of possible receiver realizations may be addressed by the underlying invention without losing generality.

When the proposed calibration method is applied, a calibration signal is fed to the first input port 102a of the mobile receiver and an LO signal with known power level is fed to the second input port 102e of said receiver as depicted in Fig. 5. A calibration signal consists of different signal levels (at least three) for each signal the level is known with different phase states. Thereby, said levels can be set by a vector signal generator as static values or as repetitive state patterns with a specific modulation frequency, which is set as low as possible.

Moreover, it should be noted that the number of different phases is preferably as high as possible, as well as the dynamic range of the input signals. According to one embodiment of the underlying invention, the total number of different amplitude and phase states is at least seven.

In mathematical processing as given by equations (1) and (2), at least seven complex sets

$$x_{LP,k} := i_k + j \cdot q_k \ \ \forall \ k \in \{0,1,2,...,6\},$$

wherein

$i_k := R_e \{x_{LP,k}\}$ denotes the $k$-th (already known) real-valued calibration coefficient for the inphase signal (I) signal obtained from the calibration coefficients computation unit 606,

$q_k := Im\{x_{LP,k}\}$ denotes the $k$-th (already known) real-valued calibration coefficient for the quadrature signal (Q) signal obtained from said calibration coefficients computation unit 606,

$x_{LP,k}$ represents the $k$-th (already known) complex-valued calibration coefficient for the equivalent low-pass signal ($x_{LP}$) derived from the real-valued calibration coefficients $i_k$ and $q_k$, and

$$j := \sqrt{-1}$$

denotes the imaginary unit, three power detector readings $P_1$, $P_2$, and $P_3$ and three squared power detector readings $F_1$, $F_2$, and $F_3$ are needed, which allows to calculate fourteen real coefficients $i_k$ and $q_k$ again.

The methodology how to solve the systems of equations is arbitrary and not relevant for the final results. By having more than seven complex data $x_{LP,k}$ (preferably as much as possible), different sets of coefficients are obtained, and by using an averaging numerical errors may be minimized.

It should be mentioned that the proposed solution according to the underlying invention leads to stable results in all of the test cases that have been checked in the process of verification.

For verification purposes, the six-port structure 105b of Fig. 2a is used. The herein applied power detectors 104a-c are commercially available detector diodes working at an operation frequency of 5 GHz. The calibration coefficients for both linear and non-linear calibration are obtained by the calibration procedure explained above.

It should be noted that for verification purposes the choice of the used six-port receiver 602 and the choice of the used power detectors 104a-c does not play a significant role. Instead, the change of the absolute values of the increased dynamic range is expected.

In the scope of said verification, a number of simulations has been carried out for both linear and non-linear calibration procedures. In Figs. 8, 9, 10 and 11, it is shown that conventional linear calibration procedures may be applied for lower power levels up to specific values where the I/Q mismatch (the discrepancies in detected values and ideal values) becomes significant and increases with the power level of the RF input signal $S_1$ fed to the six-port receiver 602. This behavior can be expected due to non-linear effects. It should be noted that in the simulation model the main source of said non-linearity is the power detector 104a-c itself. Its non-linear characteristics can be taken from Fig. 7.

On the other hand, it may be observed that the non-linear calibration approach according to the proposed solution of the underlying invention works well and compensates the non-linear behavior of said power detectors 104a-c. It can further be seen that a system using non-linear calibration offers a significantly increased range of operation. In the examples given by Fig. 9, the increase of range is around 18 dB.

Finally, it is important to stress the possible capability of the underlying approach to compensate the non-linear behavior of the total six-port receiver 602 chain. In other embodiments, the DC amplifier is also attached to the power detectors 104a-c, and a low noise amplifier (LNA) large-signal behavior can be considered.

This issue may especially be advantageous for direct down-conversion applications using mobile receivers 602 with six-port circuit topologies, where potentially automatic gain control (AGC) requirements may play a significant role.

Table: Depicted Features and their Corresponding Reference Signs

| No. | Feature |
|---|---|
| 100 | block diagram showing a general overview of the circuit topology for a mobile receiver 602 comprising a five-port junction device 102 with three power detectors 104a-c and a digital signal processor 101b according to the state of the art |
| 101a | interface for direct current (DC) signals |
| 101b | digital signal processor (DSP) |
| 102 | five-port junction device |
| 102' | six-port junction device |
| 102a | 1st port of the five-port junction device 102 or the six-port junction device 102', respectively (Port #1) = 1st port of the "five-port-like" structure 105a or the "six-port-like" structure 105b, respectively |
| 102b | 2nd port of the five-port junction device 102 or the six-port junction device 102', respectively |
| 102c | 3rd port of the five-port junction device 102 or the six-port junction device 102', respectively |
| 102d | 4th port of the five-port junction device 102 or the six-port junction device 102', respectively |

(continued)

| No. | Feature |
|---|---|
| 102e | 5th port of the five-port junction device 102 or the six-port junction device 102', respectively (Port #5) = 5th port of the "five-port-like" structure 105a or the "six-port-like" structure 105b, respectively |
| 103a | 2nd port of the "five-port-like" structure 105a or the "six-port-like" structure 105b, respectively (Port #2) |
| 103b | 3rd port of the "five-port-like" structure 105a or the "six-port-like" structure 105b, respectively (Port #3) |
| 103c | 4th port of the "five-port-like" structure 105a or the "six-port-like" structure 105b, respectively (Port #4) |
| 103d | 6th port of the "six-port-like" structure 105b (Port #6) |
| 104a | 1st power detector ($PD_1$) needed for the detection of the power $P_1$ (at Port #2) |
| 104b | 2nd power detector ($PD_2$) needed for the detection of the power $P_2$ (at Port #3) |
| 104c | 3rd power detector ($PD_3$) needed for the detection of the power $P_3$ (at Port #4) |
| 104d | 4th power detector ($PD_3$) needed for the detection of the power $P_4$ (only in case of "six-port-like" structures 105b) |
| 105a | "five-port-like" structure containing said power detectors 104a-c ($PD_1$, $PD_2$, $PD_3$) |
| 105b | "six-port-like" structure containing said power detectors 104a-c ($PD_1$, $PD_2$, $PD_3$) and one further power detector ($PD_4$) |
| 106a | power sensor of the 1st power detector 104a ($PD_1$) |
| 106b | power sensor of the 2nd power detector 104b ($PD_2$) |
| 106c | power sensor of the 3rd power detector 104c ($PD_3$) |
| 106d | power sensor of the 4th power detector 104d ($PD_4$) (only in case of "six-port-like" structures 105b) |
| 108a | low-pass (LP) filter of the 1st power detector 104a ($PD_1$) |
| 108b | low-pass (LP) filter of the 2nd power detector 104b ($PD_2$) |
| 108c | low-pass (LP) filter of the 3rd power detector 104c ($PD_3$) |
| 108d | low-pass (LP) filter of the analog circuitry 300 or 400, respectively, for the RF signal with the detected power level $P_1$ |
| 108e | low-pass (LP) filter of the analog circuitry 300 or 400, respectively, for the RF signal with the detected power level $P_2$ |
| 108f | low-pass (LP) filter of the analog circuitry 300 or 400, respectively, for the RF signal with the detected power level $P_3$ |
| 110 | passive three-port network comprising resistive components |
| 112 | non-reciprocal active circuitry comprising at least one phase shifter for executing phase shifts θ, which serves as a passive isolation between the RF signal ($S_1$) and the LO signal ($S_2$) |
| 114 | passive four-port network comprising resistive components |
| 114a | passive power divider contained in the passive four-port network 114 |
| 114b | passive three-port network comprising resistive components contained in the passive four-port network 114 |
| 200 | block diagram of a non-reciprocal active circuitry 112 for a five-port junction device 102 according to the state of the art providing a passive isolation between the RF signal ($S_1$) and the LO signal ($S_2$) |

(continued)

| No. | Feature |
|---|---|
| 300 | topology of a first analog circuitry (here: a DC amplifier network attached to the DC interface) according to one embodiment of the underlying invention that is employed to calculate the inphase (I) and quadrature (Q) signal according to three power readings ($P_1$, $P_2$, and $P_3$), thereby using analog means to execute the proposed non-linear calibration approach |
| 302a | variable gain amplifier of the analog circuitry 300 or 400 for the RF signal with the detected power level $P_1$ |
| 302b | variable gain amplifier of the analog circuitry 300 or 400 for the RF signal with the detected power level $P_2$ |
| 302c | variable gain amplifier of the analog circuitry 300 or 400 for the RF signal with the detected power level $P_3$ |
| 304a | squaring element with an automatic gain control (gain factor: $h$) for the RF signal with the detected power level $P_1$ |
| 304b | squaring element with an automatic gain control (gain factor: $h$) for the RF signal with the detected power level $P_2$ |
| 304c | squaring element with an automatic gain control (gain factor: $h$) for the RF signal with the detected power level $P_3$ |
| 306a | 1st variable gain amplifier (A, gain factor: $q_1$) for the pre-amplified RF signal with the detected power level $P_1$ |
| 306b | 2nd variable gain amplifier (B, gain factor: $i_1$) for the pre-amplified RF signal with the detected power level $P_1$ |
| 306c | 1st variable gain amplifier (C, gain factor: $q_2$) for the pre-amplified RF signal with the detected power level $P_2$ |
| 306d | 2nd variable gain amplifier (D, gain factor: $i_2$) for the pre-amplified RF signal with the detected power level $P_2$ |
| 306e | 1st variable gain amplifier (E, gain factor: $q_3$) for the pre-amplified RF signal with the detected power level $P_3$ |
| 306f | 2nd variable gain amplifier (F, gain factor: $i_3$) for the pre-amplified RF signal with the detected power level $P_3$ |
| 306g | 1st variable gain amplifier (A1, gain factor: $i_1$) for the pre-amplified and squared RF signal with the detected power level $P_1$ |
| 306h | 2nd variable gain amplifier (B1, gain factor: $q_1$) for the pre-amplified and squared RF signal with the detected power level $P_1$ |
| 306i | 1st variable gain amplifier (C1, gain factor: $i_1$) for the pre-amplified and squared RF signal with the detected power level $P_2$ |
| 306j | 2nd variable gain amplifier (D1, gain factor: $q_1$) for the pre-amplified and squared RF signal with the detected power level $P_2$ |
| 306k | 1st variable gain amplifier (E1, gain factor: $i_1$) for the pre-amplified and squared RF signal with the detected power level $P_3$ |
| 306l | 2nd variable gain amplifier (F1, gain factor: $q_1$) for the pre-amplified and squared RF signal with the detected power level $P_3$ |
| 308a | 1st summation element for adding the amplified linear and square terms and the DC offset 2 (value: $i_0$) for the in-phase (I) component |
| 308b | 2nd summation element for adding the amplified linear and square terms and the DC offset 1 (value: $q_0$) for the quadrature (Q) component |

(continued)

| No. | Feature |
|---|---|
| 310a | 1st variable gain amplifier (gain factor: $h$) in the I-chain |
| 310b | 2nd variable gain amplifier (gain factor: $h$) in the Q-chain |
| 312a | 1st analog-to-digital (A/D) converter in the I-chain |
| 312b | 2nd analog-to-digital (A/D) converter in the Q-chain |
| 314 | - in circuitry 300: (optional) digital processing unit for I/Q computation without using any non-linear calibration approach<br>- in circuitry 400: (optional) digital processing unit for I/Q computation using the proposed non-linear calibration approach according to the underlying invention |
| 316 | demodulation and further digital processing unit |
| 318 | control unit with gain tuning capability used for optional gain leveling and optional DC level adding |
| 400 | topology of a second analog circuitry (here: a DC amplifier network attached to the DC interface) according to one embodiment of the underlying invention that is employed to calculate the inphase (I) and quadrature (Q) signal according to three power readings ($P_1$, $P_2$, and $P_3$), wherein the proposed non-linear calibration approach is implemented within a digital processing block 314 |
| 500 | basic idea of eliminating the problems caused by the non-linear behavior of a mobile receiver 602 with a six-port circuit topology according to the state of the art according to the underlying invention by comparing a linear model 502a and a non-linear model 502b for the quadrature demodulator of a five-port receiver structure |
| 502a | linear model for the quadrature demodulator of a five-port receiver structure 602 with non-identical amplification in-accuracies, splitting imperfections, reflection matching, DC offsets, DC amplifier issues, and specific semiconductor process issues |
| 502b | non-linear model for the quadrature demodulator of a five-port receiver structure 602 with linear issues (non-identical amplification inaccuracies, splitting imperfections, reflection matching, DC offsets, DC amplifier issues, and specific semiconductor process tolerances) and non-linear issues (non-linear power sensor/detector readings, non-linear amplifications in the RF chain and in the analog DC chain) |
| 600 | block diagram showing a mobile receiver 602 with a six-port circuit topology and its calibration hardware 604, which is capable of executing different calibration set-up options for the calibration procedure according to the underlying invention |
| 602 | mobile receiver with a six-port circuit topology having an extended dynamic range |
| 604 | calibration hardware executing the calibration procedure according to the underlying invention |
| 606 | calibration coefficients computation unit |
| 606a | data acquisition part of the calibration coefficients computation unit 606 |
| 606b | computation part of the calibration coefficients computation unit 606 |
| 608 | combined unit consisting of the continuous wave (CW) source 608a and the unit 608b executing different calibration set-up options |
| 608a | continuous wave (CW) source or local oscillator (LO) |
| 608b | unit executing different calibration set-up options that can be applied to the calibration hardware 604:<br>- option #1: generation of different predefined I/Q values for a given CW signal<br>- option #2: (very slow) modulation of the CW signal by a predefined I/Q sequence |
| 610 | calibration coefficients memory of the quadrature demodulator 502b |

(continued)

| No. | Feature |
|---|---|
| 611a | 1st RF input port supplied with the power level $P_1$ of the respective signal measured by the power detector 104a at the respective output port 102b of the six-port junction device 102' |
| 611b | 2nd RF input port supplied with the power level $P_2$ of the respective signal measured by the power detector 104b at the respective output port 102c of the six-port junction device 102' |
| 611c | 3rd RF input port supplied with the power level $P_3$ of the respective signal measured by the power detector 104c at the respective output port 102d of the six-port junction device 102' |
| 612 | input port of the quadrature demodulator 502b supplied with calibration signals for a compensation of the non-linear behavior of the power detectors 104a-c |
| 614a | output port of the mobile receiver 602 for the inphase (I) signal calculated by the quadrature demodulator 502b |
| 614b | output port of the mobile receiver 602 for the quadrature (Q) signal calculated by the quadrature demodulator 502b |
| 616a | RF output port of the calibration hardware 604 supplied with a slowly modulated RF signal serving as a common reference having exactly the same carrier frequency as the received RF band-pass signal |
| 616b | RF output port of the calibration hardware 604 supplied with a continuous wave signal originating from a local oscillator 608a |
| 700a | diagram showing the non-linear behavior of a commercially available power detector 104a/b/c |
| 700b | first simulation circuitry serving as topology for a single-ended power detector 104a/b/c |
| 700c | second simulation circuitry serving as topology for a differential power detector 104a/b/c |
| 800a | first I/Q diagram showing the equivalent low-pass signal serving as a complex baseband signal of the down-converted RF signal $S_1$ after having applied a linear calibration procedure according to the state of the art for low RF power levels (-50, -40, and -30 dBm) at the input port of a mobile receiver 602 with a six-port circuit topology when non-linear effects of said receiver 602 become significant |
| 800b | second I/Q diagram showing the equivalent low-pass signal serving as a complex baseband signal of the down-converted RF signal $S_1$ after having applied a linear calibration procedure according to the state of the art for high RF power levels (-20, -10, -5, 0, and +3 dBm) at the input port of said mobile receiver 602 when non-linear effects of said receiver 602 become significant |
| 900a | first I/Q diagram showing the equivalent low-pass signal serving as a complex baseband signal of the down-converted RF signal $S_1$ after having applied a non-linear calibration procedure according to the proposed approach of the underlying invention for low RF power levels (-50, -40, and -30 dBm) at the input port of a mobile receiver 602 with a six-port circuit topology when non-linear effects of said receiver 602 become significant |
| 900b | second I/Q diagram showing the equivalent low-pass signal serving as a complex baseband signal of the down-converted RF signal $S_1$ after having applied a non-linear calibration procedure according to the proposed approach of the underlying invention for high RF power levels (-20, -10, -5, 0, and +3 dBm) at the input port of said mobile receiver 602 when non-linear effects of said receiver 602 become significant |

**Claims**

1. A quadrature demodulator attached to a six-port junction device (102') used for the processing and direct down-conversion of a modulated RF band-pass signal ($S_1$) to the baseband, the quadrature demodulator comprising

   - at least three RF input ports (611a-c) supplied with the power levels ($P_1$, $P_2$, $P_3$) of the respective signals measured by power detectors (104a-c) at respective output ports (102b-d) of said six-port junction device (102'),
   - at least one input port (612) supplied with a calibration signal for a compensation of a non-linear behavior of said power detectors (104a-c),
   - at least one DC processing block used for processing said power levels ($P_1$, $P_2$, $P_3$) based on said calibration signal data, which is connected to said power detectors (104a-c) over a DC interface (101a),
   - two output ports (614a+b) for the inphase (I) and quadrature (Q) signal respectively,

   **characterized in that**
   said quadrature demodulator (502b) is adapted to calculate a linear combination of the power levels ($P_1$, $P_2$, $P_3$) and a linear combination of the squared power levels ($F_1$, $F_2$, $F_3$) for a non-linear mismatch compensation of the inphase signal (I) and/or the quadrature signal (Q).

2. A quadrature demodulator according to claim 1,
   **characterized in that**
   said quadrature demodulator (502b) is realized as a passive network.

3. A quadrature demodulator according to anyone of the claims 1 and 2,
   **characterized in that**
   the linear combination of the power levels ($P_1$, $P_2$, $P_3$) and the linear combination of the squared power levels ($F_1$, $F_2$, $F_3$) are realized by means of an analog DC processing block comprising low-pass filters (108a-f), variable gain amplifiers (302a-c, 304a-c, 306a-1, and 310a+b) whose gain values are defined based on calibration signal data, summation elements (308a+b) and analog-to-digital converters (312a+b).

4. A quadrature demodulator according to anyone of the claims 1 and 2,
   **characterized in that**
   the linear combination of the power levels ($P_1$, $P_2$, $P_3$) and the linear combination of the squared power levels ($F_1$, $F_2$, $F_3$) are realized by means of a digital signal processor (101b) using the calibration signal data.

5. A quadrature demodulator according to claim 3,
   **characterized by**
   an integration of the analog processing circuitry (300/400) and the mobile receiver (602) on the same chip.

6. A non-linear calibration device for calibrating a mobile receiver (602) used for the processing and direct down-conversion of a modulated RF band-pass signal to the baseband, the mobile receiver (602) comprising a quadrature demodulator attached to a six-port junction device according to claim 1 comprising

   - at least two RF output ports (616a+b), wherein one RF out-put port (616b) is supplied with a continuous wave signal originating from a local oscillator (608a), and the other RF output port (616a) is supplied with a slowly modulated RF signal serving as a common reference, thereby having exactly the same carrier frequency as the received modulator RF band-pass signal, and
   - a calibration coefficients computation unit (606) comprising a data acquisition part (606a) attached to output ports (103a-c) of power detectors (104a-c) of a six-port junction device, a mathematical computation block (606b) for calculating sets of at least seven equations with seven unknowns, and means for providing calculated calibration coefficients derived from the mathematical computation block (606b) in the memory (610) of the mobile receiver (602).

7. A non-linear calibration device according to claim 6,
   **characterized in that**
   it is connected to the mobile receiver (602) by means of three interfaces in such a way that the RF output ports (616a+b) of the calibration device (604) are attached to the RF input port (102a) and LO input port (102e) of the mobile receiver (602), the data acquisition part (606a) of the calibration coefficients computation unit (606) is attached to the output ports (103a-c) of the power detectors (104a-c), and the computation part (606b) of the calibration coefficients computation unit (606) is attached to the calibration coefficients memory (610) of the I/Q demodulator (502b) of the mobile receiver (602).

8. A calibration method for compensating mismatches of the inphase signal (I) and/or quadrature signal (Q) using a non-linear calibration device according to anyone of the claims 6 and 7,
**characterized by** the steps of

- setting the operation frequency for which a non-linear calibration procedure is desired,
- defining a modulation sequence with at least seven different states and at least three magnitude states,
- supplying the RF input ports (102a+e) of the six-port junction device (102') of said mobile receiver (602) with one modulated RF signal ($S_1$) and one unmodulated LO signal ($S_2$), respectively,
- acquiring the power detector readings $(P_1, P_2, P_3)$ measured by the power detectors (104a-c) by the data acquisition part (606a) of the calibration coefficients computation unit (606),
- solving at least one system of seven complex equations and seven complex-valued unknowns by the computation part (606b) of the calibration coefficients computation unit (606), thereby providing a set of at least fourteen real-valued calibration coefficients, and
- transferring said calibration coefficients to the control and gain tuning unit of the mobile receiver (602).

9. A calibration method according to claim 8,
**characterized by**

- executing a cyclic repetition of said steps, thereby providing at least two different sets of the fourteen real-valued calibration coefficients, and
- applying a step for minimizing numerical errors by means of a minimum square error procedure which is directly integrated within the process of the mathematical computation block, thereby serving as a system equation solver for a set of seven complex equations, before transferring said calibration coefficients to the control and gain tuning unit of the mobile receiver (602).

10. A calibration method according to anyone of the claims 8 and 9,
**characterized in that**
the calibration procedure is performed off-line after chip manufacturing and/or chip assembly.

11. A calibration method according to anyone of the claims 8 to 10,
**characterized in that**

- said calibration procedure is performed for different operation frequencies within the operation range of the mobile receiver (602), and
- the obtained set of at least fourteen real-valued calibration coefficients is stored in the calibration coefficients memory (610) of the mobile receiver (602).

12. A calibration method according to anyone of the claims 8 to 10,
**characterized in that**
said calibration procedure is performed for the center frequency of different operation frequency bands, thereby using the same calibration coefficients for an operation frequency close to said center frequency.

13. A calibration method according to anyone of the claims 8 to 10,
**characterized in that**
said calibration procedure is performed for the center frequency of different operation frequency bands, thereby using extrapolated and/or interpolated calibration coefficients for an operation frequency close to said center frequency.

14. A receiver of a mobile telecommunications device used for the processing and direct down-conversion of a modulated RF band-pass signal ($S_1$) to the baseband represented by the quadrature components (I and Q) of the equivalent low-pass signal forming the complex envelope of said RF band-pass signal, comprising

- at least two RF input ports (102a+e) supplied with the modulated RF band-pass signal ($S_1$) and a continuous wave signal ($S_2$) originating from a local oscillator (608a), respectively, which are fed to the input ports (102a+e) of a six-port junction device (102') serving as a passive isolation between said input signals ($S_1$ and $S_2$),

- at least four power detectors (104a-c) used for detecting the power levels ($P_1, P_2, P_3$) of the respective signals at the output ports (102b-d) of said six-port junction device (102'),
- at least one input port (612) supplied with calibration signals for a compensation of the non-linear behavior of said power detectors (104a-c),
- at least one DC processing block used for processing said power levels ($P_1, P_2, P_3$), which is connected with said power detectors (104a-c) over an interface (101a) for direct current (DC) signals, and
- at least two output ports (614a+b) for the inphase signal (I) and the quadrature signal (Q), respectively,

wherein

said six-port junction device (102') comprises two passive $N$-port networks (110, 114) connected to each other by a non-reciprocal circuitry (112), wherein each of said passive $N$-port networks (110, 114) is connected to one of said RF input ports (102a+e), respectively,
**characterized in that**
it comprises
a quadrature demodulator according to anyone of the claims 1 to 5 and a non-linear calibration device according to anyone of the claims 6 and 7, which is attached to said six-port junction device (102').

### Patentansprüche

1.  Quadratur-Demodulator, der an eine Sechstor-Verzweigungseinrichtung (102') angeschlossen ist, die zur Verarbeitung und zur direkten Abwärtskonvertierung eines modulierten RF-Bandpasssignals ($S_1$) auf das Basisband verwendet wird, wobei der Quadratur-Demodulator umfasst:

    - mindestens drei RF-Eingangsanschlüsse (611a-c), an denen Leistungspegel ($P_1, P_2, P_3$) der entsprechenden Signale bereitgestellt werden, die durch Leistungsdetektoren (104a-c) an den entsprechenden Ausgangsanschlüssen (102b-d) der Sechstor-Verzweigungseinrichtung (102') gemessen werden,
    - mindestens einen Eingangsanschluss (612), an dem ein Kalibriersignal für eine Kompensation eines nicht-linearen Verhaltens der Leistungsdetektoren (104a-c) angelegt ist,
    - mindestens einen DC-Verarbeitungsblock, der zum Verarbeiten der Leistungspegel ($P_1, P_2, P_3$) anhand der Kalibrationssignaldaten verwendet wird, und der mit den Leistungsdetektoren (104a-c) über eine DC-Schnittstelle (101a) verbunden ist,
    - zwei Ausgangsanschlüsse (614a+b) für das Gleichtakt- (I) bzw. das Quadratur-(Q) Signal,

    **dadurch gekennzeichnet, dass**
    der Quadratur-Demodulator (502b) ausgebildet ist, um eine lineare Kombination der Leistungspegel ($P_1, P_2, P_3$) und eine lineare Kombination der quadratischen Leistungspegel ($F_1, F_2, F_3$) für eine nicht-lineare Fehlanpassung des Gleichtakt-Signals (I) und/oder des Quadratur-Signals (Q) zu berechnen.

2.  Quadratur-Demodulator nach Anspruch 1,
    **dadurch gekennzeichnet, dass** der Quadratur-Demodulator (502b) als ein passives Netzwerk realisiert ist.

3.  Quadratur-Demodulator nach einem der Ansprüche 1 oder 2, **dadurch gekennzeichnet, dass**
    die lineare Kombination der Leistungspegel ($P_1, P_2, P_3$) und die lineare Kombination der quadratischen Leistungspegel ($F_1, F_2, F_3$) mit Hilfe eines analogen DC-Verarbeitungsblocks realisiert werden, der Tiefpassfilter (108a-f), Verstärker (302a-c, 304a-c, 306a-1 und 310a+b) mit variabler Verstärkung, deren Verstärkungswerte abhängig von Kalibriersignaldaten definiert sind, Summationselemente (308a+b) und Analog-Digital-Wandler (312a+b) umfasst.

4.  Quadratur-Demodulator nach einem der Ansprüche 1 und 2,
    **dadurch gekennzeichnet, dass**
    die lineare Kombination der Leistungspegel ($P_1, P_2, P_3$) und die lineare Kombination der quadratischen Leistungspegel ($F_1, F_2, F_3$) mit Hilfe eines digitalen Signalprozessors (101b) mit Hilfe der Kalibriersignaldaten realisiert werden.

5.  Quadratur-Demodulator nach Anspruch 3,
    **gekennzeichnet durch** eine Integration des Analogverarbeitungsschaltkreises (300/400) und des mobilen Empfängers (602) auf demselben Chip.

**6.** Nicht-lineare Kalibrationsvorrichtung zum Kalibrieren eines mobilen Empfängers (602), der zur Verarbeitung und Abwärtskonvertierung eines modulierten RF-Bandpasssignals auf ein Basisband verwendet wird, wobei der mobile Empfänger (602) einen Quadratur-Demodulator umfasst, der mit einer Sechstor-Verzweigungseinrichtung gemäß Anspruch 1 verbunden ist, umfassend:

- mindestens zwei RF-Ausgangsanschlüsse (616a+b), wobei an einen RF-Ausgangsanschluss (616b) ein Signal mit einer kontinuierlichen Schwingung angelegt wird, das von einem lokalen Oszillator (608a) stammt, und an den anderen RF-Ausgangsanschluss (616a) ein langsam moduliertes RF-Signal, das als eine gemeinsame Referenz dient, angelegt wird, das **dadurch** exakt die gleiche Trägerfrequenz aufweist wie das empfangene modulierte RF-Bandpasssignal, und
- eine Kalibrierkoeffizienten-Berechnungseinheit (606), die ein Datenerfassungselement (606a), das mit den Ausgangsanschlüssen (103a-c) der Leistungsdetektoren (104a-c) einer Sechstor-Verzweigungseinrichtung verbunden ist, ein Mathematische-Berechnungs-Element (606b) zum Berechnen von Gruppen von mindestens sieben Gleichungen mit sieben Unbekannten und eine Einrichtung zum Bereitstellen der berechneten Kalibrierkoeffizienten umfasst, die von dem Mathematischen-Berechnungs-Element (606b) in dem Speicher (610) des mobilen Empfängers (602) abgeleitet sind.

**7.** Nicht-lineare Kalibrationsvorrichtung nach Anspruch 6,
**dadurch gekennzeichnet, dass**
sie mit dem mobilen Empfänger (602) mit Hilfe von drei Schnittstellen so verbunden ist, dass die RF-Ausgangsanschlüsse (616a+b) der Kalibrationseinrichtung (604) mit dem RF-Eingangsanschluss (102a) und mit einem LO-Eingangsanschluss (102e) des mobilen Empfängers (602) verbunden sind, dass das Datenerfassungselement (606a) der Kalibrierkoeffizienten-Berechnungseinheit (606) mit den Ausgangsanschlüssen (103a-c) der Leistungsdetektoren (104a-c) verbunden ist, und dass das Berechnungselement (606b) der Kalibrierkoeffizienten-Berechnungseinheit (606) mit dem Kalibrierkoeffizientenspeicher (610) des I/Q-Demodulators (502b) des mobilen Empfängers (602) verbunden ist.

**8.** Kalibrierverfahren zum Kompensieren von Fehlanpassungen des Gleichtakt-Signals

(I) und/oder des Quadratur-Signals (Q) mit Hilfe einer nicht-linearen Kalibrationsvorrichtung gemäß einem der Ansprüche 6 und 7,

**gekennzeichnet durch** die Schritte:

- Einstellen der Betriebsfrequenz, bei der eine nicht-lineare Kalibrierung gewünscht ist,
- Definieren einer Modulationssequenz mit mindesten sieben verschiedenen Zuständen und mindestens drei Amplitudenzuständen,
- Anlegen eines modulierten RF-Signals ($S_1$) und eines unmodulierten LO-Signals ($S_2$) an die RF-Eingangsanschlüsse (102a+b) der Sechstor-Verzweigungseinrichtung (102') des mobilen Empfängers (602),
- Erfassen der Leistungsdetektormesswerte ($P_1$, $P_2$, $P_3$), die **durch** die Leistungsdetektoren (104a-c) **durch** das Datenerfassungselement (606a) der Kalibrierkoeffizienten-Berechnungseinheit (606) gemessen werden,
- Lösen von mindestens einem System mit sieben komplexen Gleichungen und sieben komplex-wertigen Unbekannten **durch** das Berechnungselement (606b) der Kalibrierkoeffizienten-Berechnungseinheit (606), wodurch eine Menge von mindestens 14 realwertigen Kalibrierkoeffizienten bereitgestellt wird, und
- Übertragen der Kalibrierkoeffizienten an die Steuer- und Verstärkungseinstelleinheit des mobilen Empfängers (602).

**9.** Kalibrierverfahren nach Anspruch 8, **gekennzeichnet durch**:

- Ausführen einer zyklischen Wiederholung der Schritte, wodurch mindestens zwei verschiedene Mengen von 14 realwertigen Kalibrierkoeffizienten bereitgestellt werden, und
- Anwenden eines Schrittes zum Minimieren der numerischen Fehler mit Hilfe eines Verfahrens der kleinsten quadratischen Fehler, das direkt in den Prozess des Mathematische-Berechnungs-Blockes integriert ist, wodurch dieses als ein Systemgleichungslöser für eine Menge von sieben komplexen Gleichungen dient, bevor die Kalibrierkoeffizienten an die Steuer- und Verstärkungseinstelleinheit des mobilen Empfängers (602) übertragen werden.

**10.** Kalibrierverfahren nach einem der Ansprüche 8 und 9,

**dadurch gekennzeichnet, dass**
das Verfahren offline nach der Chipherstellung und/oder dem Zusammenbau des Chips durchgeführt wird.

11. Kalibrierverfahren nach einem der Ansprüche 8 bis 10,
**dadurch gekennzeichnet, dass**

- das Kalibrierverfahren für verschiedene Betriebsfrequenzen des Arbeitsbereichs des mobilen Empfängers (602) durchgeführt wird, und
- die erhaltene Menge von mindestens 14 realwertigen Kalibrierkoeffizienten in dem Kalibrierkoeffizientenspeicher (610) des mobilen Empfängers (602) gespeichert wird.

12. Kalibrierverfahren nach einem der Ansprüche 8 bis 10,
**dadurch gekennzeichnet, dass**
das Kalibrierverfahren für die Mittenfrequenz von verschiedenen Betriebsfrequenzbändern durchgeführt wird, wodurch dieselben Kalibrierkoeffizienten für eine Betriebsfrequenz nahe der Mittenfrequenz verwendet werden.

13. Kalibrierverfahren nach einem der Ansprüche 8 bis 10,
**dadurch gekennzeichnet, dass**
das Kalibrierverfahren für die Mittenfrequenz von verschiedenen Betriebsfrequenzbändern durchgeführt wird, wodurch extrapolierte und/oder interpolierte Kalibrierkoeffizienten für eine Betriebsfrequenz nahe der Mittenfrequenz verwendet werden.

14. Empfänger für ein mobiles Telekommunikationsgerät, das zur Verarbeitung und direkten Abwärtskonvertierung eines modulierten RF-Bandpasssignals ($S_1$) auf das Basisband verwendet wird, das durch die Quadratur-Komponenten (I und Q) des äquivalenten Signals, das die komplexe Hülle des RF-Bandbasssignals bildet, dargestellt wird, umfassend:

- mindestens zwei RF-Eingangsanschlüsse (102a+e), an denen das modulierte RF-Bandpasssignal ($S_1$) bzw. ein Signal ($S_2$) mit einer kontinuierlichen Schwingung, das von einem lokalen Oszillator (608a) stammt, bereitgestellt werden, und die an die zwei Eingangsanschlüsse (102a+e) der Sechstor-Verzweigungseinrichtung (102'), die als eine passive Isolation zwischen den Eingangssignalen ($S_1$ und $S_2$) dient, angelegt werden,
- mindestens vier Leistungsdetektoren (104a-c), die zum Detektieren der Leistungspegel ($P_1$, $P_2$, $P_3$) der entsprechenden Signale an den Ausgangsanschlüssen (102b-d) der Sechstor-Verzweigungseinrichtung (102) verwendet werden,
- mindestens einen Eingangsanschluss (612), an den Kalibriersignale für eine Kompensation des nicht-linearen Verhaltens der Leistungsdetektoren (104a-c) angelegt werden,
- mindestens einen DC-Verarbeitungsblock, der zur Verarbeitung der Leistungspegel ($P_1$, $P_2$, $P_3$) verwendet wird, die an die Leistungsdetektoren (104a-c) über eine Schnittstelle (101a) für Gleichstromsignale (DC) angelegt sind, und
- mindestens zwei Ausgangsanschlüsse (614a+b) für das Gleichtakt-Signal (I) bzw. das Quadratur-Signal (Q),
- wobei die Sechstor-Verzweigungseinrichtung (102') zwei passive N-Tor-Netzwerke (110, 114) umfasst, die miteinander über einen nicht-reziproken Schaltkreis (112) verbunden sind, wobei jedes der passiven N-Tor-Netzwerke (110, 114) jeweils mit einem der RF-Eingangsanschlüsse (102a+e) verbunden ist,

**dadurch gekennzeichnet, dass**
er einen Quadratur-Demodulator nach einem der Ansprüche 1 bis 5 und eine nicht-lineare Kalibrationsvorrichtung nach einem der Ansprüche 6 und 7, die an die Sechstor-Verzweigungseinrichtung (102') angeschlossen ist, umfasst.

**Revendications**

1. Un démodulateur en quadrature associé à un dispositif de jonction à six ports (102') utilisé pour le traitement et la conversion descendante directe vers la bande de base d'un signal passe- bande RF modulé ($S_1$), le démodulateur en quadrature comprenant

- au moins trois ports d'entrée RF (611a-c) recevant les niveaux de puissance ($P_1$, $P_2$, $P_3$) des signaux respectifs mesurés par des détecteurs de puissance (104a-c) à des ports de sortie respectifs (102b-d) du dispositif de jonction à six ports (102'),

- au moins un port d'entrée (612) recevant un signal d'étalonnage pour une compensation d'un comportement non linéaire des détecteurs de puissance (104a-c),
- au moins un bloc de traitement en courant continu utilisé pour traiter les niveaux de puissance ($P_1$, $P_2$, $P_3$) sur la base des données de signal d'étalonnage, qui est connecté aux détecteurs de puissance (104a-c) par l'intermédiaire d'une interface à courant continu (101 a),
- deux ports de sortie (614a+b) respectivement pour le signal en phase (I) et le signal en quadrature (Q),

**caractérisé en ce que**
le démodulateur en quadrature (502b) est adapté pour calculer une combinaison linéaire des niveaux de puissance ($P_1$, $P_2$, $P_3$) et une combinaison linéaire des niveaux de puissance au carré ($F_1$, $F_2$, $F_3$) pour une compensation de désadaptation non linéaire du signal en phase (I) et/ou du signal en quadrature (Q).

**2.** Un démodulateur en quadrature selon la revendication 1,
**caractérisé en ce que**
le démodulateur en quadrature (502b) est réalisé sous la forme d'un réseau passif.

**3.** Un démodulateur en quadrature selon l'une quelconque des revendications 1 et 2
**caractérisé en ce que**
la combinaison linéaire des niveaux de puissance ($P_1$, $P_2$, $P_3$) et la combinaison linéaire des niveaux de puissance au carré ($F_1$, $F_2$, $F_3$) sont réalisées au moyen d'un bloc de traitement en courant continu analogique comprenant des filtres passe-bas (108a-f), des amplificateurs à gain variable (302a-c, 304a-c, 306a-1 et 310a+b) dont les valeurs de gain sont définies sur la base de données de signal d'étalonnage, des éléments de sommation (308a+b) et des convertisseurs analogique - numérique (312a+b).

**4.** Un démodulateur en quadrature selon l'une quelconque des revendications 1 et 2,
**caractérisé en ce que**
la combinaison linéaire des niveaux de puissance ($P_1$, $P_2$, $P_3$) et la combinaison linéaire des niveaux de puissance au carré ($F_1$, $F_2$, $F_3$) sont réalisées au moyen d'un processeur de signal numérique (101b) utilisant les données de signal d'étalonnage.

**5.** Un démodulateur en quadrature selon la revendication 3,
**caractérisé par**
une intégration du circuit de traitement analogique (300/400) et du récepteur mobile (602) sur la même puce.

**6.** Un dispositif d'étalonnage non linéaire pour étalonner un récepteur mobile (602) utilisé pour le traitement et la conversion descendante directe vers la bande de base d'un signal passe-bande RF modulé, le récepteur mobile (602) comprenant un démodulateur en quadrature associé à un dispositif de jonction à six ports conforme à la revendication 1, comprenant

- au moins deux ports de sortie RF (616a+b), parmi lesquels un port de sortie RF (616b) reçoit un signal d'oscillation entretenue provenant d'un oscillateur local (608a), et l'autre port de sortie RF (616a) reçoit un signal RF modulé lentement, remplissant la fonction d'une référence commune, ayant ainsi exactement la même fréquence porteuse que le signal passe-bande RF modulé reçu, et
- une unité de calcul de coefficients d'étalonnage (606) comprenant une section d'acquisition de données (606a) associée à des ports de sortie (103a-c) de détecteurs de puissance (104a-c) d'un dispositif de jonction à six ports, un bloc de calcul mathématique (606b) pour résoudre des systèmes d'au moins sept équations à sept inconnues, et un moyen pour fournir à la mémoire (610) du récepteur mobile (602) des coefficients d'étalonnage calculés, obtenus à partir du bloc de calcul mathématique (606b).

**7.** Un dispositif d'étalonnage non linéaire selon la revendication 6,
**caractérisé en ce que**
il est connecté au récepteur mobile (602) au moyen de trois interfaces, d'une manière telle que les ports de sortie RF (616a+b) du dispositif d'étalonnage (604) soient associés au port d'entrée RF (102a) et au port d'entrée d'oscillateur local (102a) du récepteur mobile (602), la section d'acquisition de données (606a) de l'unité de calcul de coefficients d'étalonnage (606) soit associée aux ports de sortie (103a-c) des détecteurs de puissance (104a-c), et la section de calcul (606b) de l'unité de calcul de coefficients d'étalonnage (606) soit associée à la mémoire de coefficients d'étalonnage (610) du démodulateur 1/Q (502b) du récepteur mobile (602).

**8.** Un procédé d'étalonnage pour compenser des désadaptations du signal en phase (I) et/ou du signal en quadrature (Q) en utilisant un dispositif d'étalonnage non linéaire selon l'une quelconque des revendications 6 et 7, **caractérisé par** les étapes consistant à

- fixer la fréquence de fonctionnement pour laquelle on désire une procédure d'étalonnage non linéaire,
- définir une séquence de modulation avec au moins sept états différents et au moins trois états d'amplitude,
- appliquer aux ports d'entrée RF (102a+e) du dispositif de jonction à six ports (102') du récepteur mobile (602), respectivement un signal RF modulé ($S_1$) et un signal d'oscillateur local non modulé ($S_2$),
- acquérir les valeurs de détecteur de puissance ($P_1$, $P_2$, $P_3$) mesurées par les détecteurs de puissance (104a-c), au moyen de la section d'acquisition de données (606a) de l'unité de calcul de coefficients d'étalonnage (606),
- résoudre au moins un système de sept équations complexes et de sept inconnues à valeurs complexes, par la section de calcul (606b) de l'unité de calcul de coefficients d'étalonnage (606), pour fournir ainsi un ensemble d'au moins quatorze coefficients d'étalonnage à valeurs réelles, et
- transférer les coefficients d'étalonnage vers l'unité de commande et de réglage de gain du récepteur mobile (602).

**9.** Un procédé d'étalonnage selon la revendication 8, **caractérisé par**

- l'exécution d'une répétition cyclique desdites étapes, pour fournir ainsi au moins deux ensembles différents des quatorze coefficients d'étalonnage à valeurs réelles, et
- l'application d'une étape pour minimiser des erreurs numériques au moyen d'un procédure d'erreur quadratique minimale qui est directement intégrée au processus du bloc de calcul mathématique, pour qu'il remplisse ainsi la fonction d'un dispositif de résolution d'équations de système, pour un système de sept équations complexes, avant de transférer les coefficients d'étalonnage à l'unité de commande et de réglage de gain du récepteur mobile (602).

**10.** Un procédé d'étalonnage selon l'une quelconque des revendications 8 et 9, **caractérisé en ce que** la procédure d'étalonnage est accomplie en mode différé, après fabrication de la puce et/ou assemblage de la puce.

**11.** Un procédé d'étalonnage selon l'une quelconque des revendications 8 à 10, **caractérisé en ce que**

- la procédure d'étalonnage est accomplie pour différentes fréquences de fonctionnement dans la plage de fonctionnement du récepteur mobile (602), et
- l'ensemble obtenu d'au moins quatorze coefficients d'étalonnage à valeurs réelles est stocké dans la mémoire de coefficients d'étalonnage (610) du récepteur mobile (602).

**12.** Un procédé d'étalonnage selon l'une quelconque des revendications 8 à 10, **caractérisé en ce que** la procédure d'étalonnage est accomplie pour la fréquence centrale de différentes bandes de fréquences de fonctionnement, et on utilise ainsi les mêmes coefficients d'étalonnage pour une fréquence de fonctionnement proche de la fréquence centrale.

**13.** Un procédé d'étalonnage selon l'une quelconque des revendications 8 à 10, **caractérisé en ce que** la procédure d'étalonnage est accomplie pour la fréquence centrale de différentes bandes de fréquences de fonctionnement, et on utilise ainsi des coefficients d'étalonnage extrapolés et interpolés pour une fréquence de fonctionnement proche de la fréquence centrale.

**14.** Un récepteur d'un dispositif de télécommunication mobile utilisé pour le traitement et la conversion descendante directe d'un signal passe-bande RF modulé ($S_1$), vers la bande de base représentée par les composantes en quadrature (I et Q) du signal passe-bas équivalent formant l'enveloppe complexe du signal passe-bande RF, comprenant :

- au moins deux ports d'entrée RF (102a+e) recevant le signal passe-bande RF modulé ($S_1$) et un signal d'oscillation entretenue ($S_2$) provenant d'un oscillateur local (608a), respectivement, qui sont appliqués aux ports d'entrée (102a+e) d'un dispositif de jonction à six ports (102') constituant une isolation passive entre les signaux d'entrée ($S_1$ et $S_2$),

- au moins quatre détecteurs de puissance (104a-c) utilisés pour détecter les niveaux de puissance ($P_1$, $P_2$, $P_3$) des signaux respectifs aux ports de sortie (102b-d) du dispositif de jonction à six ports (102'),

- au moins un port d'entrée (612) recevant des signaux d'étalonnage pour une compensation du comportement non linéaire des détecteurs de puissance (104a-c),

- au moins un bloc de traitement en courant continu utilisé pour traiter les niveaux de puissance ($P_1$, $P_2$, $P_3$), qui est connecté au détecteur de puissance (104-c) par l'intermédiaire d'une interface (101a) pour des signaux à courant continu (DC), et

- au moins deux ports de sortie (614a+b) respectivement pour le signal en phase (I) et le signal en quadrature (Q),

dans lequel

le dispositif de jonction à six ports (102') comprend deux réseaux à N ports passifs (110, 114) connectés l'un à l'autre par un circuit non réciproque (112), dans lequel chacun des réseaux à N ports passifs (110, 114) est connecté respectivement à l'un des ports d'entrée RF (102a+e),

**caractérisé en ce que**

il comprend

un démodulateur en quadrature selon l'une quelconque des revendications 1 à 5 et un dispositif d'étalonnage non linéaire selon l'une quelconque des revendications 6 et 7, qui est associé au dispositif de jonction à six ports (102').

Fig. 1

EP 1 376 852 B1

Fig. 2a

EP 1 376 852 B1

114   114b                     114a

connection                                              $P_o$: t 1        $S_1$
to 112    ←——————→ | Passive | ←→ | Passive |  ←——————
                    | Three-  |     | Power   |        RF
                    | Port    |     | Divider |  102a  Signal
                    | 102c    |     | 102b    |

              connection              connection
              to 104b                 to 104a

Fig. 2b

Fig. 2c

R5 R5 R5

110

112 θ

R6 R5 R2 R1 R4 R3

114

Signal 2 ($S_2$) at Port 5 (102e)

$PD_3$ 104c Port 4 (103c)

$PD_2$ 104b Port 3 (103b)

105a

$PD_1$ 104a Port 2 (103a)

RF Signal 1 ($S_1$) at Port 1 (102a)

RF Signal $(S_1)$

LO Signal $(S_2)$

105

102a (Port 1)
104a PD1
Port 2
$P_1$
103a

A
104c PD3
C
B
Port 3
$P_3$
103b

104b PD2
102e (Port 5)
Port 4
$P_2$
103c

DC Interface
101a

Fig. 24

Fig. 3

Fig. 4

**500**

**502a** **614a** **614b**

**Linear Entity**
non-identical amplification innacuracies,
splitting
imperfections, reflection
matching, DC offsets, DC amplifier issues
specific semiconductor process issues

LO Power Value
Is considered as Constant

*I*

*Q*

I/Q Values are LINEAR
COMBINATION of the
acquired power readings

$P_1, P_2, and P_3$

**502b** **614a** **614b**

**NON-Linear Entity**
Linear Issues:
non-identical amplification innacuracies, splitting
imperfections, reflection
matching, DC offsets, DC amplifier issues,
semiconductor process tolerances

Non-Linear Issues
non-linear power sensor/detector readings,
non-linear amplifications in RF Chain and in the
DC analog Chain

LO Power Value
Is considered as Constant

*I*

*Q*

I/Q Values are NON-LINEAR
COMBINATION of the
acquired power readings

$P_1, P_2, and P_3$

**HYPOTHESIS:**

IF I/Q Values are NON-
LINEAR COMBINATION of
the acquired power
readings

$P_1, P_2, and P_3$

THEN

I/Q Values may be treated as Linear COMBINATION
(as a first approximation)
of the acquired power readings $P_1, P_2, and P_3$
and Linear COMBINATION of the
**second powers** of the acquired power readings

= Polynomial extrapolation of the non linear function

**Fig. 5**

EP 1 376 852 B1

Fig. 6

Fig. 7

for RF power = [-20 -10 -5 0 3] dBm

$\chi_{LP}$

800b

b)

for RF power = [-50 -40 -30] dBm

$\chi_{LP}$

800a

a)

Fig. 8

**900a**

for RF power = [-50 -40 -30] dBm

**900b**

for RF power = [-20 -10 -5 0 3] dBm

a)

b)

Fig. 9

EP 1 376 852 B1

34